# EUROPEAN PATENT APPLICATION

(11) **EP 3 944 305 A1**
(43) Date of publication of application: **26.01.2022**
(21) Application number: 21184644.9
(22) Date of filing: 09.07.2021
(51) Int. Cl.: H01L 23/16, H01L 21/56, H01L 23/29, H01L 25/18

(54) **POWER SEMICONDUCTOR DEVICE PACKAGE AND METHOD OF ASSEMBLING THEREOF**

(30) Priority: 22.07.2020 US 202016935826
(71) Applicant: Infineon Technologies Americas Corp., El Segundo, CA 90245 (US)
(72) Inventor: ERGAS, Franck, San Jose, CA 95120 (US)
(74) Representative: Westphal, Mussgnug & Partner, Patentanwälte mbB

(57) **Abstract**

A semiconductor device includes a power semiconductor device, a circuit board, and an insulating substrate. The power semiconductor device includes contact pads. Adjacent ones of the contact pads are separated by one of a plurality of gaps. The circuit board includes traces for coupling with the contact pads of the power semiconductor device. The contact pads are physically attached to the traces. The insulating substrate is disposed between the circuit board and the power semiconductor device, where portions of the insulating substrate are disposed in the plurality of gaps, and where the insulating substrate has a monolithic structure.

## Description

The present invention relates generally to semiconductors, and in particular embodiments, to semiconductor device packages and methods for assembling.

Dielectric breakdown in space may occur as air is not a perfect insulator. When exposed to electric fields higher than a dielectric strength, the dielectric such as air breaks down. Gas molecules become ionized in the air space between the conductors and create a current between the conductors. The distance between the conductors also factor into the breakdown. As the density of the air decreases, the electric field strength required to form ionization and breakdown decreases. The breakdown characteristics for a gas can be described by Paschen law and Paschen curve. The Paschen curve is a graphic representation of the relationship between the gas breakdown voltage and gas pressure. According to Paschen curve, the air breakdown voltage will drop in lower air pressure environments such as in high altitudes. When semiconductor devices attached together through contacts are brought into space, the air space between the contacts could become regions with lower breakdown voltage.

Corona effect is a partial electrical discharge caused by the ionization of a medium, such as air, surrounding an electrically charged conductor. Corona discharge is thus a type of localized emission resulting from transient gaseous ionization in an insulation system when the voltage stress, i.e., voltage gradient, exceeds a critical value. The ionization is usually localized over only a portion of the distance between the electrodes of the insulation system.

Although the corona effect is a low energy process, it can substantially degrade insulators and cause a system to fail due to dielectric breakdown. In general, the corona effect/discharge is a concern in high voltage applications, such as power lines with >10KV, as it could cause power loss/waste and degrade the insulation of the power transmission line related components and equipment. In many applications, the corona discharge is a precursor to occurrence of a destructive arcing problem that could cause serious damage to circuit components. The effects of corona are cumulative and permanent, and failure can occur without warning. Corona effect can be generally avoided by minimizing the voltage stress and electric field gradient.

However, the corona discharge becomes more problematic in low pressure environments such as space and high altitudes. As the density of the air decreases, the dielectric strength of air also decreases causing dielectric breakdown at lower electric fields. This can be more problematic in high voltage semiconductor devices. In particular, in high voltage semiconductor chips, adjacent electrodes may have a large voltage difference (e.g., between an electrode biased to positive/negative and a reference ground electrode). When these devices are exposed to low pressure environments such as in space or high altitudes, corona discharge can become a problem.

In addition, high voltage systems for space applications have to ensure that ground operations do not reduce in-space reliability. For example, replacement parts and components with high voltage semiconductor chips may be stored on Earth for many years before space deployment and hence these have to be designed to prevent failure from environmental degradation such as corrosion and other phenomenon such as out-gassing that can occur during storage.

The corona discharge in high voltage semiconductor components is reduced by maximizing the gap between adjacent contacts, avoiding contacts with sharp, pointing, non-smooth edges or shapes, and improving cleanliness of the contacts. Further, the gap between contacts can be filled with "void-free" potting with silicon or epoxy to effectively increase the gap/creepage distance. Susceptibility to corona discharge has been improved by using a surface coating with high dielectric strength such as Parylene, to enclosure the conductive surface thereby increasing the gap and reducing the electric field between adjacent contacts. One existing method used to insulate conductors is the use of silicone based filler injected in between a die and substrate also known as Glob Top.

In accordance with an embodiment of the present application, a semiconductor device includes a power semiconductor device, a circuit board, and an insulating substrate. The power semiconductor device includes contact pads. Adjacent ones of the contact pads are separated by one of a plurality of gaps. The circuit board may include traces for coupling with the contact pads of the power semiconductor device. The contact pads may be physically attached to the traces. The insulating substrate is disposed between the circuit board and the power semiconductor device, where portions of the insulating substrate are disposed in the plurality of gaps, and where the insulating substrate has a monolithic structure.

In accordance with another embodiment of the present application, a semiconductor device includes an enhancement mode GaN power transistor, a printed circuit board, and a rigid insulating substrate. The enhancement mode GaN power transistor is configured to operate at an operating voltage between 20 V and 1000 V and includes contact pads. The printed circuit board is configured to support operating voltage and includes contact surfaces for coupling with the contact pads of the enhancement mode GaN power transistor. The rigid insulating substrate is disposed between the printed circuit board and the enhancement mode GaN power transistor. The contact pads are physically attached to the contact surfaces through a plurality of through holes in the rigid insulating substrate.

In accordance with another embodiment of the present application, a method of assembling a semiconductor device includes placing an insulating substrate over a circuit board, placing a power semiconductor device over the circuit board and the insulating substrate, and heating the circuit board and power semiconductor device to cure the insulating substrate and attach contact pads with traces. The insulating substrate includes an insulating material and is a monolithic structure. The power semiconductor device includes contact pads and the circuit board includes traces. The contact pads are aligned with traces for attaching the contact pads on the circuit board. Adjacent ones of the contact pads are separated by one of a plurality of gaps.

For a more complete understanding of the present invention, and the advantages thereof, reference is now made to the following descriptions taken in conjunction with the accompanying drawings, in which:
Figures 1A-1E schematically illustrate a semiconductor assembly comprising a semiconductor device in accordance with embodiments of the present disclosure, wherein Figure 1A illustrates a top view, Figures 1B and 1C illustrate cross-sectional views, Figure 1D is one example illustration of an insulating substrate and Figure 1E is one example illustration of an enclosure;
Figure 2A-2F illustrates a cross-sectional view of a process of assembling a semiconductor device 200 according to embodiments of the present disclosure;
Figure 3A-3D illustrates tops views of embodiments of power semiconductor devices highlighting different contact pad arrangements;
Figure 4A-4D illustrates projection views of an insulating substrate associated with a contact pad arrangement of Figures 3A-3D in accordance with embodiments of the present disclosure; and
Figure 5 illustrates a flowchart of a method of assembling a semiconductor device in accordance with embodiments of the present disclosure.

The presently preferred embodiments, including their making and use, are discussed in detail below. However, it should be appreciated that the present application supplies many applicable inventive concepts which can be embodied in a wide variety of specific contexts. The specific embodiments discussed here are merely descriptive of specific ways to assemble and use the invention. These specific embodiments do not limit the scope of the invention.

As previously discussed, corona discharge is an unwanted side effect in many high voltage applications. A corona discharge occurs when a current flows from a one conductor with high potential to another conductor at a lower potential through a medium, such as air, ionizing the medium surrounding the conductor and resulting in dielectric breakdown between adjacent conductors. Several factors such as potential difference between the conductors, shape and diameter, and surface irregularities may affect a conductor's electrical surface gradient and its relationship with corona effect. These factors, as well as dielectric breakdown between the conductors, can result in irreversible premature aging and failure of semiconductor devices due to corona effect.

Accordingly, there is a need for a device to prevent the effects of corona discharge for space applications. Various embodiments of the present application described herein minimize or eliminate the corona effect between adjacent conductors by filling the air space between conductors. One existing method of reducing corona discharge is by injecting silicone based fillers between contacts. However, this particular method may not be preferred in hermetically sealed hybrid packages due to outgassing of materials used in the fillers.

In various embodiments, an insulating substrate is introduced between the semiconductor components that are being assembled so as to replace the empty space that would be filled with the filling gas with a dielectric material having a higher dielectric strength. Unlike filler material that may continue to outgas during storage, the insulating substrate may be fabricated into a much more thermodynamically stable state that does not undergo this issue. Accordingly, various embodiments of the present invention disclose an insulating substrate that can be used to separate contacts on surface mount devices such as ball grid array (BGA) and line grid array (LGA) devices, and a method of assembling the insulating substrate on a semiconductor device.

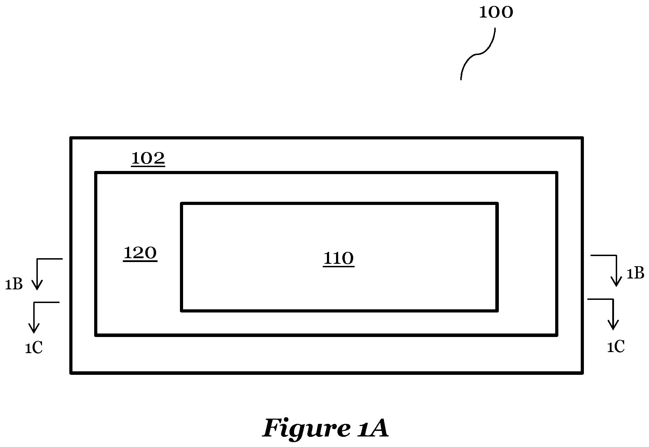

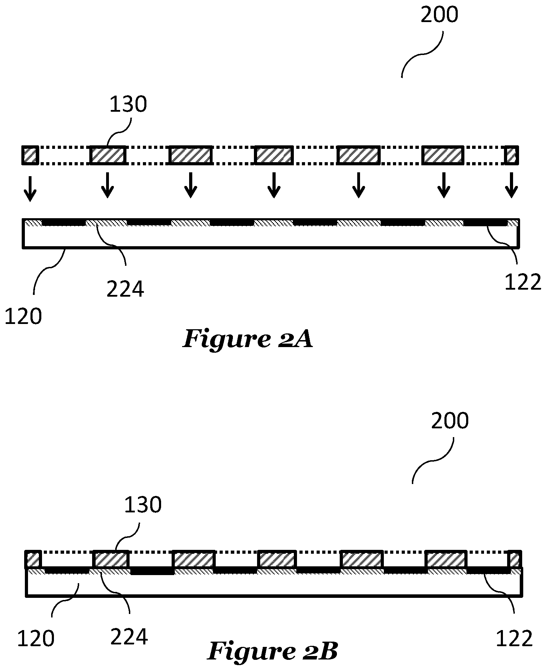

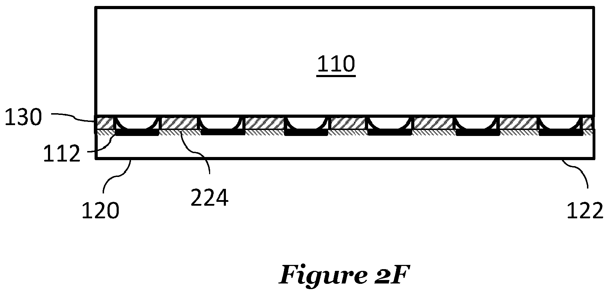

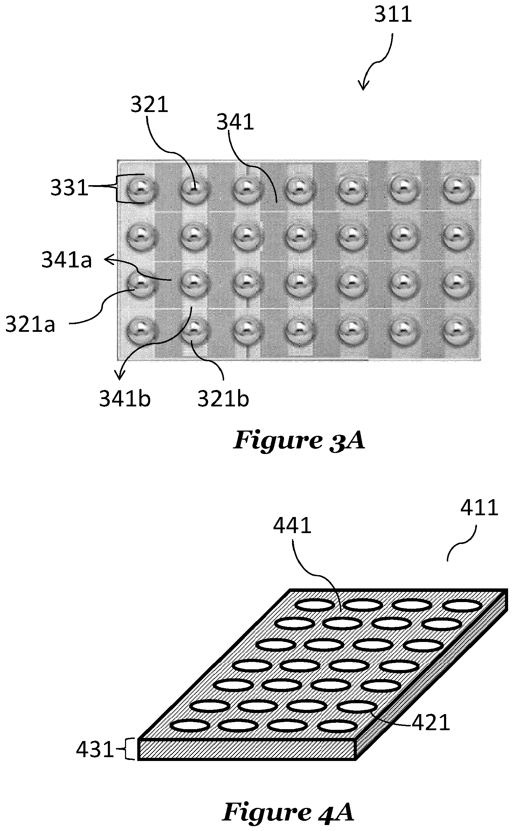

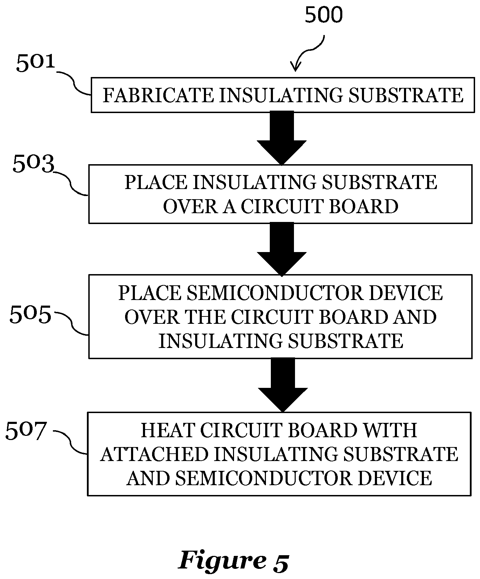

An embodiment of a semiconductor assembly that has better resistance to corona discharge will be described using Figures 1A-1E followed by alternative embodiments using Figures 4A-4D. Various methods of assembling this semiconductor assembly will be described using Figures 2A-2F and 5.

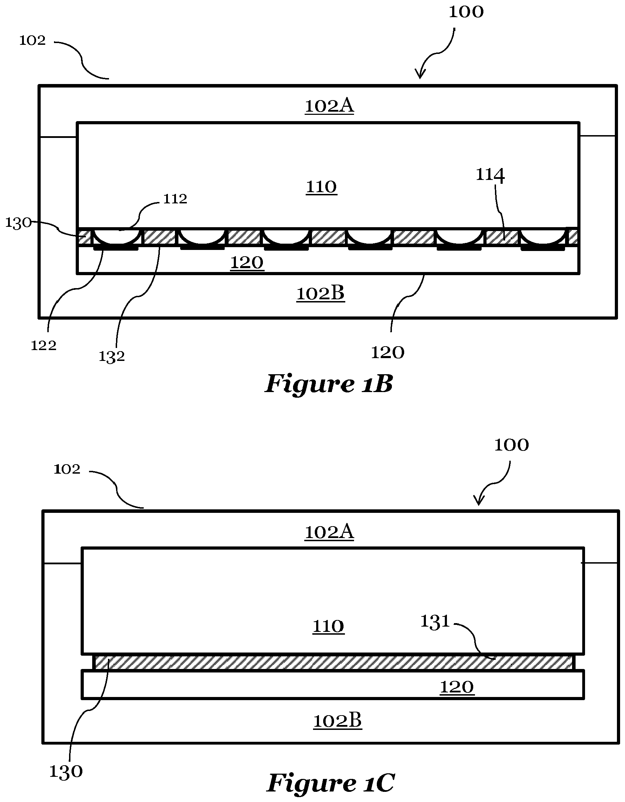

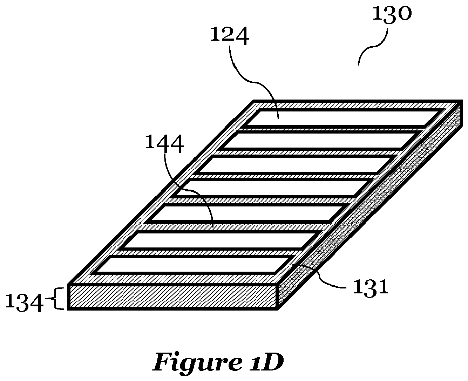

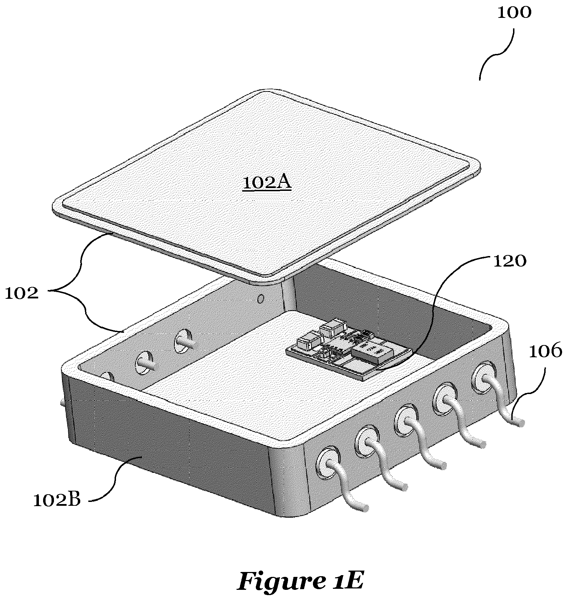

Figures 1A-1E schematically illustrate a semiconductor assembly comprising a semiconductor device in accordance with embodiments of the present disclosure, wherein Figure 1A illustrates a top view, Figures 1B and 1C illustrate cross-sectional views, Figure 1D is one example illustration of an insulating substrate and Figure 1E is one example illustration of an enclosure.

Referring to Figures 1A-1C, a semiconductor device 110 may be a power semiconductor device. The power semiconductor device may be configured to operate at high voltages, for example, between 20 V and 600 V, or above 20V in one embodiment. In certain embodiments, the power semiconductor device may be configured to operate at voltages between 40 V and 200 V.

In various embodiments, the semiconductor device 110 may comprise a semiconductor device made of GaN, or other wide band gap materials such as silicon carbide or gallium oxide. In various embodiments, the semiconductor device 110 comprises a transistor such as a field effect transistor. In certain embodiments, the semiconductor device 110 comprises a discrete field effect transistor such as an n-channel field effect transistor or a p-channel field effect transistor. In some embodiments, the semiconductor device 110 may comprise an n-type GaN field effect transistor configured to operate at voltages between 40V and 1000V. In one embodiment, the semiconductor device 110 may comprise an enhancement mode GaN power transistor configured to operate at voltages between 20V and 1000V. In one embodiment, the semiconductor device 110 may be a lateral GaN device formed on a silicon substrate.

The semiconductor device 110 may be semiconductor package such as a ball grid array package, land grid array package (e.g., BGA without the protruding balls), or a line grid array package. Accordingly, the semiconductor device 110 may include a semiconductor die, for example, a GaN semiconductor device that is attached to a ceramic substrate.

As better illustrated in Figure 1B, the semiconductor device 110 comprises contact pads 112, where adjacent ones of the contact pads 112 are separated by one of a plurality of gaps 114. In various embodiments, the semiconductor device 110 may comprise various contact pad 112 arrangements.

As illustrated in Figures 1A-1C, the semiconductor assembly 100 includes a circuit board 120 for connecting the semiconductor device 110 to external leads of the assembly. The circuit board 120 may be a printed circuit board in certain embodiments and may include a number of metal layers or a thick film. In certain embodiments, the circuit board 120 may comprise a thin film metalized substrate. The circuit board 120 may be configured to support the operating voltage of the power transistor, for example, maybe configured to support operation of an enhancement mode GaN power transistor. The circuit board 120 may also include other devices such as low voltage logic devices that are not illustrated in Figures 1A-1C. The circuit board 120 connects the semiconductor device 110 to other components of the circuit board 120 and/or to external nodes of the semiconductor assembly. Accordingly, the circuit board 120 may include metallization for other components such as low voltage integrated circuits, and discrete components. These additional components may be interconnected through the metallization of the circuit board 120 or externally through wire bonds.

As illustrated in Figure 1B, the circuit board 120 further comprises traces 122 for the coupling the contact pads 112 of the semiconductor device 110. The traces 122 may be buried within the circuit board 120 in certain embodiments. However, in certain embodiments, the traces 122 may include conductive pads protruding above a major surface of the circuit board 120. The protruding conductive pads maybe defined by a solder mask to ensure proper placement and alignment of the contact pads 112 of the semiconductor device 110. The contact pads 112 may be physically directly attached to the traces 122 but in some embodiments the contact pads 112 may be attached to the traces 122 through an intermediary adhesive layer such as a solder or additional conductive interposer. In certain embodiments, the contact pads 112 may comprise contact surfaces that are coplanar with the major outer surface of the circuit board 120.

As further illustrated in Figures 1B-1D, an insulating substrate 130, e.g., a monolithic structure, is disposed between the semiconductor device 110 and the circuit board 120. The insulating substrate 130 is a prefabricated insulating substrate in one embodiment. In certain embodiments, the insulating substrate 130 comprises a rigid insulating substrate. The insulating substrate 130 is aligned so as to fill the plurality of gaps 114. As illustrated, for example, in Fig. 1C, portions 132 of the insulating substrate are disposed in the plurality of gaps 114. Accordingly, the insulating substrate 130 occupies the plurality of gaps 114 reducing the volume of space that may otherwise be filled with a gas. The insulating substrate 130 electrically isolates each contact pad 112 from neighboring contact pads 112. In various embodiments, the insulating substrate 130 is made of an insulating material substrate and includes no other electrical connections or circuitry such as metallic traces to avoid any potential for electrical shorts or enhancing corona effect. In certain embodiments, the insulating substrate 130 may include a frame 131 in a peripheral region along the edge of the power semiconductor device 110 as best observed in Figure 1C-1D.

The insulating substrate 130 is configured to occupy the plurality of gaps 114 corresponding to the various contact pad 112 arrangements. In certain embodiments, the insulating substrate 130 may have various configurations to align with the traces 122 of a circuit board 129 and the contact pads 112. In various embodiments, the insulating substrate 130 may have alternative configurations to align with the contact pads 112 of the semiconductor device 110. These alternative configurations will be described in further embodiments below, for example, in Figures 3A-4D.

Figure 1D illustrates one embodiment that may be used with a number of different designs since it comprises parallel trenches 124 separated by ridges 144. The parallel trenches 124 are through holes that extend completely through from one side of the insulating substrate 130 to the other side of the insulating substrate 130. This design of the insulating substrate 130 is compatible with different contact pad arrangement as long as the correct pitch between the trenches 124 and width of the trenches 124 is selected for that particular semiconductor device 110 (or arrangement of contact pads 112).

The insulating substrate 130 has a thickness 134 less than a height of the plurality of contact pads 112 so as to ensure that the contact pads 112 directly contact the traces 122 of the circuit board 120. If the height of the plurality of contact pads 112 is less than the thickness of the insulating substrate 130, the plurality of contact pads 112 may not make contact with the traces 122 of the circuit board 120. Additionally, the height of the contact pads 112 may influence the reliability, electrical, and thermal performance of the semiconductor device 110. Thus, the thickness of the insulating substrate 130 may be selected according to the corresponding height of the contact pads 112.

In various embodiments, the insulating substrate 130 comprises an insulating material having a dielectric strength that is greater than air or inert gases that would otherwise be present. In various embodiments, the insulating substrate 130 may be composed of epoxy, glass, or other insulating materials.

As illustrated in Figure 1B-1C and 1E, an enclosure 102 may enclose the semiconductor device 110 and the circuit board 120. As illustrated in Figures 1B-1C and 1E, the enclosure 102 may include a cover 102A that is attached to a body 102B in a sealed manner. In various embodiments, the enclosure 102 hermetically seals the semiconductor device 110 and the circuit board 120 from an outside environment. As is evident, if not for the insulating substrate 130, the plurality of gaps 114 will be filled with the gas that is sealed within the enclosure 102. In other words, the insulating substrate 130 replaces part of the gas separating adjacent ones of the contact pads 112 as well as adjacent ones of the traces 122.

The enclosure 102 may be hermetically sealed to keep gas and environmental debris away from the electronic parts. In various embodiments, the enclosure 102 may be hermetically sealed by seam sealing or laser welding, for example. In some embodiments, the enclosure 102 may be hermetically sealed in a chamber containing an inert gas such as nitrogen to dry out the moisture level below a threshold such as 5000 ppm. In certain embodiments, the enclosure 102 may be sealed in an environment with nitrogen and helium, for example, with 90% N₂ and 10% He, to test for hermiticity. Helium may be mixed with nitrogen as a tracer gas to detect leaks in the enclosure 102.

The enclosure 102 may also protect the semiconductor assembly 100 from contamination, moisture, temperature, radiation, and corrosion. In various embodiments, a hermetically sealed semiconductor assembly 100 may extend the lifespan of the semiconductor assembly 100 during storage by protecting the components from corrosion. Such a semiconductor assembly 100 may be safely stored for many years, for example, 10-20 years before deployment in space.

For contacting with external components, as illustrated in Figure 1E, the semiconductor assembly 100 further includes a plurality of leads 106 extending out of the enclosure 102. The plurality of leads 106 may be coupled to pads on the circuit board 120 and in certain embodiments may be directly attached to the circuit board 120. In one or more embodiments, the plurality of leads 106 may be coupled to the circuit board 120 through other intervening components within the enclosure 102.

Figure 2A-2F illustrates a cross-sectional view of a process of assembling a semiconductor device 200 according to embodiments of the present invention.

Figure 2A illustrates a process of aligning an insulating substrate 130 on a circuit board 120. In various embodiments, the circuit board 120 comprises a hybrid integrated circuit. The hybrid integrated circuit may comprise semiconductor devices and passive components wire bonded or soldered to a ceramic or beryllium substrate. In various embodiments, the circuit board 120 may comprise a single-sided, double-sided, or multi-layered printed circuit board or monolithic integrated circuit with vias connecting the different layers of metallizations.

The circuit board 120 includes traces 122 and a glaze 224 applied between the traces 122. In various embodiments, the traces 122 comprise an electrically conductive metal such as copper, silver, gold, or nickel. The traces 122 may comprise internal vias coupling between the various traces on the circuit board 120. The glaze 224 may be used to protect against oxidation and prevent solder bridges from forming between closely spaced traces 122. The glaze 224 may be a material used to form a solder mask in various embodiments. The glaze 224 may be applied on the circuit board 120 as a liquid such as epoxy liquid silkscreened on to the circuit board 120, liquid photoimageable inks, dry-film photoimageable solder mask or laser direct imaging. In certain embodiments, the glaze 224 may be aligned to form partly on the edges of the traces 122 so that the subsequent attachment of the contact pads 112 is symmetric while avoiding shorting.

As also illustrated in Figure 2A, the insulating substrate 130 is aligned over the circuit board 120. The insulating substrate 130 is a prefabricated component, for example, fabricated as a monolithic structure and may be an insulating material. The insulating substrate 130 may be molded or cast into shape in certain embodiments, while in certain embodiments may be 3-D printed into the final form. In certain embodiments, the insulating substrate 130 may be a glass (e.g., quartz or silicon oxide based glass) or ceramic substrate in which through holes are openings are formed by a subtractive process such as etching, punching, or cutting with laser.

In certain embodiments, the insulating substrate 130 may comprise a resin such as a thermosetting material in one embodiment. In one embodiment, the insulating substrate 130 may comprise an epoxy material. The insulating substrate 130 comprising a resin maybe formed using a molding process such as injection molding, 3-D printing, casting, or a laser process such as laser cutting or laser ablation.

In various embodiments, the insulating substrate 130 is subjected to a heat treatment process e.g., a two stage curing process, so as to settle into a stable state in which it can be maintained for several years without decaying, for example, outgassing or reactive to the external environment. In addition, the insulating substrate 130 comprises a material that is able to undergo the heat treatment processes relating to the reflow process. In various embodiments, the associated insulating substrate may be composed of epoxy injected into a mold to form the associated insulating substrate. In alternative embodiments, the associated insulating substrate may be composed of insulating material with a dielectric strength greater than 3 kV/mm and between 3 kV/mm to 10 kV/mm.

In various embodiments, the insulating substrate 130 may be aligned to enclose the glaze 224 leaving the traces 122 exposed. In alternative embodiments, the insulating substrate 130 may be aligned to enclose the glaze 224 and may enclose some of the traces 122. In one embodiment, the insulating substrate 130 may be aligned with a pick and place machine by using a vacuum suction tool with a coordinated z-axis movement (vertical in plane of paper). The pick and place machine may be programmed to precisely align the insulating substrate 130 to the circuit board 120 and released onto the circuit board 120.

Figure 2B illustrates the semiconductor device 200 after the insulating substrate 130 is placed onto the circuit board 120. As illustrated, the insulating substrate 130 is supported on the circuit board 120.

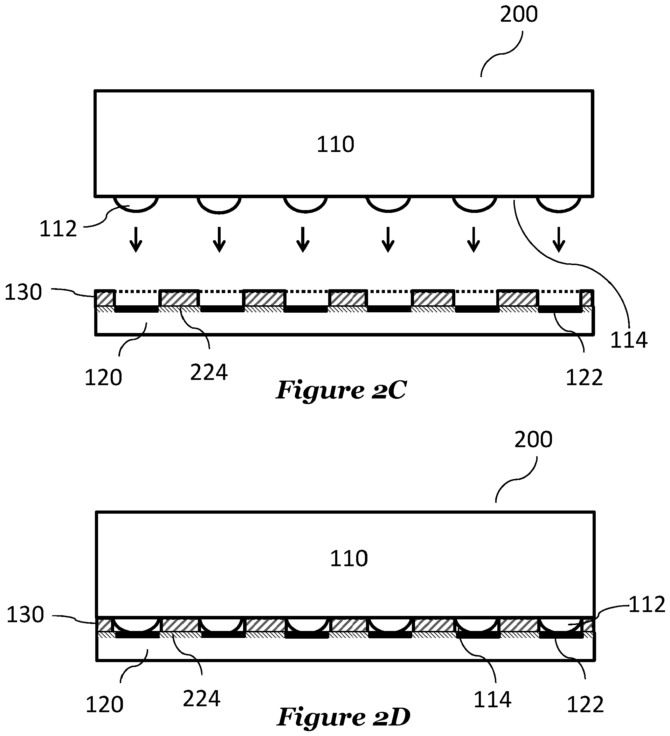

Figure 2C illustrates a process of attaching a semiconductor device 110 over the insulating substrate 130 and the circuit board 120. The semiconductor device 110 is aligned with and arranged over the insulating substrate 130. The semiconductor device 110 includes contact pads 112 arranged, for example, in a grid array and a plurality of gaps 114. The contact pads 112 may comprise balls in one embodiment (e.g., in case of ball grid array package) but in another embodiment may comprise planar pads coplanar with the major surface of the semiconductor device 110 (e.g., in case of land grid array package).

According, at this stage, the contact pads 112 of the semiconductor device 110 are aligned with the traces 122 of the circuit board 120. In various embodiments, the semiconductor device 110 may be aligned and placed with a pick and place machine or die bonder system to transfer the semiconductor device 110 to a precise position on the circuit board 120.

Figure 2D illustrates a cross-sectional view of the semiconductor device 200 after the insulating substrate 130 and the semiconductor device 110 have been placed on the circuit board 120. The insulating substrate 130 occupies the plurality of gaps 114 between the contact pads 112 of the semiconductor device 110.

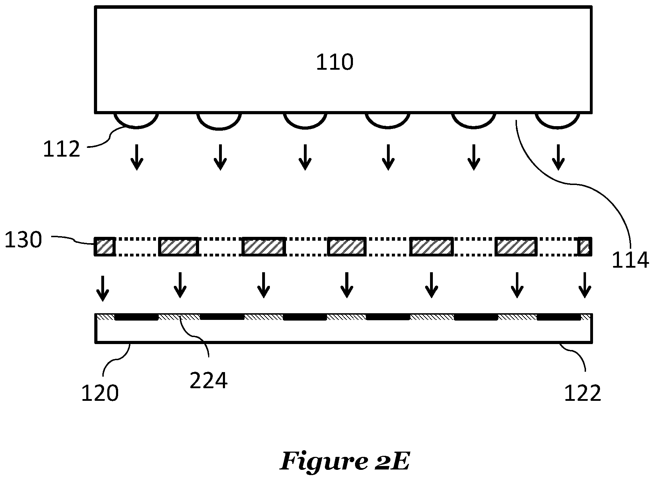

Figure 2E illustrates a cumulative process of attaching the semiconductor device 110 and the insulating substrate 130 on the circuit board 120 as described in the embodiments of Figures 2A-2D. With the semiconductor device 110 and the insulating substrate 130 assembled on the circuit board 120, the semiconductor device 200 may undergo reflow soldering to bond the contact pads 112 of the semiconductor device 110 to the traces 122 of the circuit board 120 and bond the insulating substrate 130 to the glaze 224. The reflow soldering may take place, for example, in a reflow oven or under an infrared lamp. In various embodiments, a vacuum soldering system may be used for reflow soldering the contact pads 112 of the semiconductor device 110 and to cure the insulating substrate 130 simultaneously. In certain embodiments, an additional epoxy or polymer coating may be introduced to fill any voids between the insulating substrate 130 and the contact pads 112 before the reflow soldering.

The reflow soldering and curing process includes several stages: a preheat stage, a thermal soak stage, a reflow stage, and a cooling stage. In the preheat stage, the semiconductor device 200 may be heated to a consistent and linear pre-reflow temperature to prevent damage to components and to allow volatile solvents to safely outgas. The semiconductor device 200 then undergoes the thermal soak stage to expel volatile substances and for flux activation. In the reflow stage, the semiconductor device 200 reaches a maximum allowable temperature for adequate reflowing and curing without damaging vulnerable components. In the cooling stage, the semiconductor device 200 is gradually cooled to solidify the insulating substrate 130 and the contact pads 112 to the traces 122.

With the insulating substrate 130 in place, each of the plurality of contact pads 112 and traces 122 is electrically isolated from the next one of the plurality of contact pads 112 and traces 122. In other words, the path between adjacent contacts is spaced by a region of the insulating substrate 130, which has a higher dielectric strength. Consequently, the device assembly is able to minimize the potential of causing corona discharge when the device travels in space.

Figures 3A-3D illustrate top views of various semiconductor devices highlighting the contact pad arrangement while Figures 4A-4D illustrate projection views of an associated insulating substrate in accordance with an embodiment of the present disclosure. Each of the semiconductor device of Figures 3A-3D may be an embodiment of the semiconductor device 110 discussed with respect to Figures 1-2, while similarly each of the insulating substrate of Figures 4A-4D maybe an embodiment of the insulating substrate 130 discussed in Figures 1-2 above. Of course, as previously discussed, the embodiment insulating substrate of Figure 1D may be also used with these semiconductor devices of Figures 3A-3D.

Referring to Figures 3A-3D generally, as previously discussed, semiconductor device includes contact pads separated by one of a plurality of gaps. The contact pads include a corresponding contact pad dimension and contact pad height. The plurality of gaps includes corresponding vertical gap spacings and horizontal gap spacings.

The semiconductor device may comprise a ball grid array (BGA) or line grid array (LGA) device. In some embodiments, the semiconductor device may comprise various predefined package sizes, for example, 3.5mm by 2 mm or 6.5 mm by 2.3 mm. The contact pads and the plurality of gaps may be arranged in numerous arrangements and may include various contact pad dimensions of the semiconductor device.

The contact pads may be arranged in an array comprising rows and columns. The contacts pads in central regions of the semiconductor device are spaced from a first neighboring contact pad of the contact pads along a row of the array and a second neighboring contact pad of the contact pads along a column of the array. The plurality of contacts pads are separated from adjacent one of the contact pads by a plurality of gaps. In various embodiments, the plurality of gaps may have a vertical gap spacing adjacent the first neighboring contact pad and a horizontal gap spacing adjacent the second neighboring contact pad.

In various embodiments, the contact pads 112 may be configured with alternating columns for source and drain and a gate may be configured to a single (or a few) contact pad positioned on a corner of the semiconductor device, for example. In alternative embodiments, the contact pads may be parallel columns separated by the plurality of gorges between each column forming a line grid array (LGA) device.

As illustrated in Figure 3A, a first semiconductor device 311 includes first contact pads 321 arranged in a ball grid array of rows and columns and a first plurality of gaps 341 adjacent the first contact pads 321. The first contact pads 321 may have a contact pad dimension 331 that is equally distant from the center of the contact pad. The first plurality of gaps 341 include first vertical gap spacings 341a between each column of first contact pads 321 and first horizontal gap spacings 341b between each row of first contact pads 321. The first vertical gap spacings 341a adjacent a first neighboring contact pad 321a and the first horizontal gap spacings 341b adjacent a second neighboring contact pad 321b. The first vertical gap spacing 341a and the first horizontal gap spacing 341b may have the same dimensions.

As illustrated in Figure 4A, a first associated insulating substrate 411 includes a first plurality of holes 421 separated by a first plurality of interconnecting regions 441. The first plurality of holes 421 are through holes that extend completely through from one side of the first associated insulating substrate 411 to the other side of the first associated insulating substrate 411. The first plurality of interconnecting regions 441 is configured to be disposed in the first plurality of gaps 341 of the first semiconductor device 311. The first plurality of holes 421 are arranged in an array of rows and columns according to the arrangement of the first contact pads 321.

The first associated insulating substrate 411 includes a thickness 431 that is less than a height of the first contact pads 321 to attach the first contact pads 321 to traces on a circuit board when the first semiconductor device 311 is joined with the first associated insulating substrate 411. The first associated insulating substrate 411 may be the same size as the predefined package size of the first semiconductor device 311.

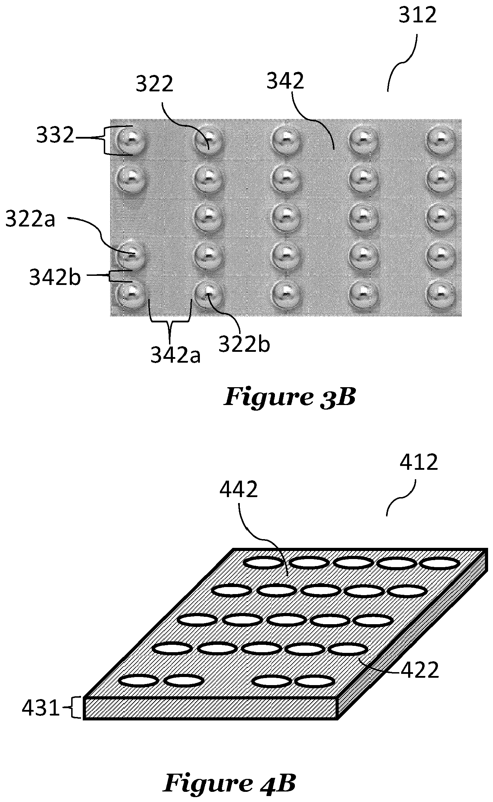

As illustrated in Figure 3B, the second semiconductor device 312 includes second contact pads 322 arranged in an array of rows and columns and a second plurality of gaps 342 adjacent the second contact pads 322. The second contact pads 322 may include a different number of contact pads in each row or column than the number of contact pads in a neighboring row or column. The second plurality of gaps 342 include second vertical gap spacings 342a between each column of second contact pads 322 and second horizontal gap spacings 342b between each row of second contact pads 322. The second vertical gap spacing 342a and the second horizontal gap spacing 342b may have different dimensions between neighboring contact pads. For example, the second vertical gap spacings 342a may be larger than the second horizontal gap spacings 342b.

As illustrated in Figure 4B, the second associated insulating substrate 412 includes a second plurality of holes 422 separated by a second plurality of interconnecting regions 442. The second plurality of holes 422 are through holes that extend completely through from one side of the second associated insulating substrate 412 to the other side of the second associated insulating substrate 412. The second plurality of interconnecting regions 442 is configured to be disposed in the second plurality of gaps 342 of the second semiconductor device 312. The second plurality of holes 422 are arranged in an array of rows and columns according to the arrangement of the second contact pads 332.

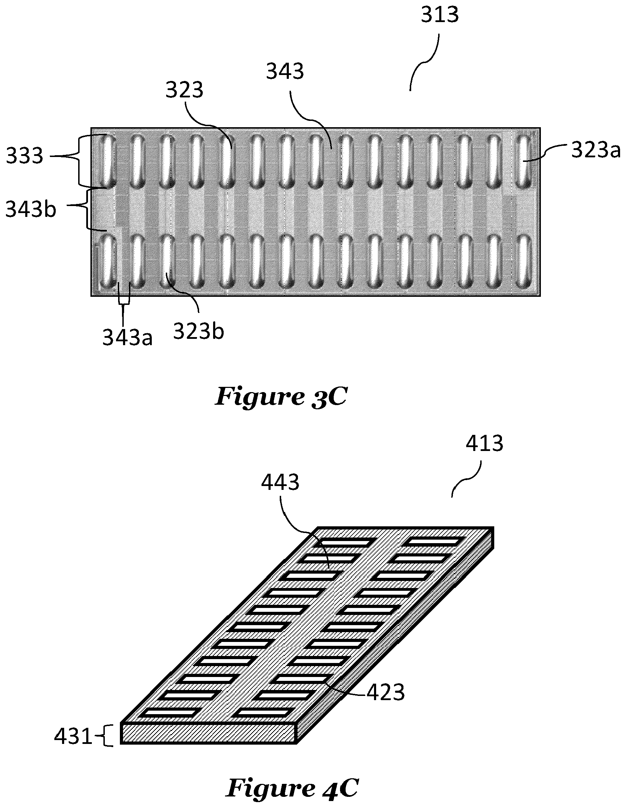

As illustrated in Figure 3C, a third semiconductor device includes third contact pads 323 arranged in rows and columns and a third plurality of gaps 343 adjacent the third contact pads 323. The third contact pads 323 include a third contact pad dimension 333. The third contact pad dimension 333 may have an elongated shape. The third plurality of gaps 343 includes third vertical gap spacings 343a between each column of third contact pads 323 and third horizontal gap spacings 343b between each row of third contact pads 323. The third vertical gap spacing 343a and the third horizontal gap spacing 343b may have different dimensions between neighboring contact pads. The third vertical gap spacings 343a may be smaller than the third horizontal gap spacings 343b.

As illustrated in Figure 4C, the third associated insulating substrate 413 includes a third plurality of holes 423 and a third plurality of interconnecting regions 443. The third plurality of holes 423 are arranged according to the arrangement of the third contact pads 323. The third plurality of holes 423 may have an elongated shape to accommodate the elongated shape of the third contact pads dimensions 333. The third plurality of holes 423 are through holes that extend completely through from one side of the third associated insulating substrate 413 to the other side of the third associated insulating substrate 413. The third plurality of interconnecting regions 443 is configured to be disposed in the third plurality of gaps 343 of the third semiconductor device 313.

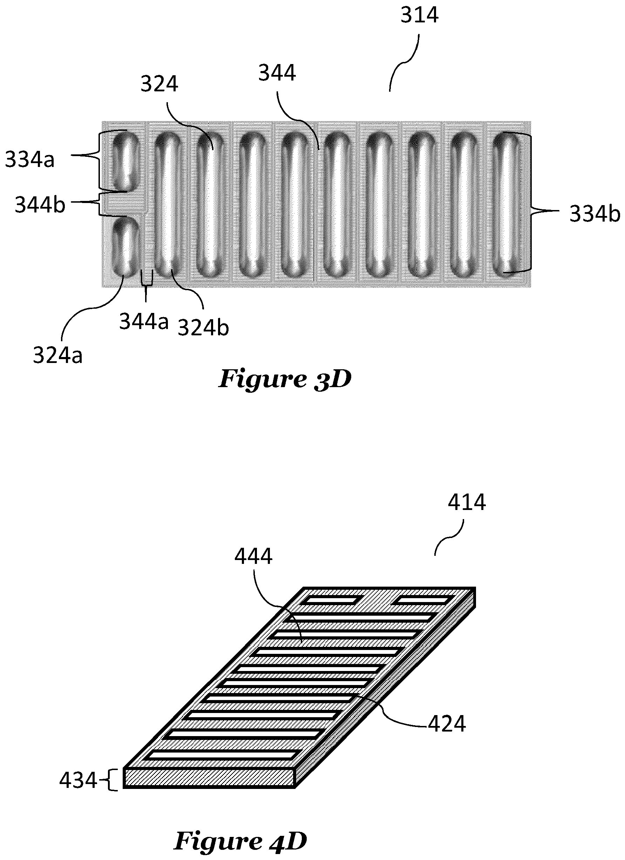

As illustrated in Figure 3D, the fourth semiconductor device 314 includes fourth contact pads 324 arranged in parallel columns and a fourth plurality of gaps 344 adjacent the fourth contact pads 324. The fourth contact pads 324 may include a column that includes multiple rows of contact pads, for example, the fourth contact pads 324a and columns of contact pads of a single row, for example, the fourth column contact pads 324b. For example, the fourth contact pads 324a may be used for a gate contact while the alternating fourth column contact pads 324b may be used for source or drain contacts. The fourth contact pads 324 may include multiple fourth contact pad dimensions. For example, the column of contact pads including multiple rows of contact pads, the fourth contact pads 324a may have a fourth contact pad dimension 334a and the column of contact pads of a single row, the fourth column contact pads 324b may have a fourth contact pad dimension 334b. The fourth plurality of gaps 344 includes fourth vertical gap spacings 344a and fourth horizontal gap spacings 344b. The fourth vertical gap spacings 344a may be smaller than the fourth horizontal gap spacings 344b.

As illustrated in Figure 4D, a fourth associated insulating substrate 414 includes a fourth plurality of holes 424 and a fourth plurality of interconnecting regions 444. The fourth plurality of holes 424 are arranged according to the arrangement of the fourth contact pads 324 illustrated in Figure 3D. The fourth plurality of holes 424 are through holes that extend completely through from one side of the fourth associated insulating substrate 414 to the other side of the fourth associated insulating substrate 414. The fourth plurality of interconnecting regions 444 is configured to be disposed in the fourth plurality of gaps 344 of the fourth semiconductor device 314.

Figure 5 illustrates a flowchart 500 representing a method of assembling a semiconductor assembly.

The method includes placing an insulating substrate over a circuit board, placing a power semiconductor device over the circuit board and the insulating substrate, contact pads being aligned with traces for the power semiconductor device on the circuit board, adjacent ones of the contact pads being separated by one of a plurality of gaps, and heating the circuit board and the power semiconductor device to cure the insulating substrate and attach the contact pads with the traces.

In block 501, an insulating substrate is prefabricated as described above in various embodiments. For example, the insulating substrate is designed to fit for a specific semiconductor device package design, as illustrated in exemplary embodiments of Figures 1D and 4A-4D. In particular, the insulating substrate comprises holes or trenches that allow contacts pads of the specific semiconductor device package to pass through. As described in various embodiments above, the insulating substrate may be a prefabricated monolithic structure comprising an insulating material.

As next illustrated in block 503, the insulating substrate is aligned with the circuit board so that the plurality of holes/trenches in the insulating substrate are aligned with the contact pads (e.g., traces) of a circuit board. This is also described with respect to Figs. 2A-2B above. Accordingly, the contact pads of the circuit board are exposed through the insulating substrate.

As next illustrated in block 505, a power semiconductor device is placed over the circuit board and insulating substrate. The semiconductor device includes contact pads that are aligned with the traces on the circuit board. The power semiconductor die may be disposed over the circuit board and the insulating substrate as described above and illustrated in Figures 2C-2D.

As next illustrated in block 507, the circuit board, the insulating substrate and the semiconductor device undergo a heat treatment process. During the heat treatment process, the circuit board, the insulating substrate, and the semiconductor device are heated from room temperature to about 200°C to 400°C, for example, 250°C to 350°C. During this process, as also described above with respect to Figure 2E, the solder material in the contact pads of the semiconductor die reflows and reacts with the material of the contact pads of the circuit board to form solder joints. In addition, the insulating substrate may help to control the flow of the solder over the surface of the circuit board.

Further examples of embodiments of the present application are provided below.
Example 1. A semiconductor device including: a power semiconductor device including contact pads, adjacent ones of the contact pads being separated by one of a plurality of gaps; a circuit board including traces for coupling with the contact pads of the power semiconductor device, the contact pads being physically attached to the traces; and an insulating substrate disposed between the circuit board and the power semiconductor device, where portions of the insulating substrate are disposed in the plurality of gaps, and where the insulating substrate has a monolithic structure.
Example 2. The device of example 1, further including: an enclosure in which the circuit board and the power semiconductor device are disposed, the enclosure hermetically sealing the power semiconductor device and the circuit board from an outside environment.
Example 3. The device of one of examples 1 or 2, further including: a low voltage integrated circuit chip attached to the circuit board.
Example 4. The device of one of examples 1 to 3, where the power semiconductor device includes a Ball Grid Array (BGA) package or a Line Grid Array (LGA) package.
Example 5. The device of one of examples 1 to 4, where the insulating substrate is made of an insulating material that includes a dielectric strength greater than 3 kV/mm.
Example 6. The device of one of examples 1 to 5, where the insulating substrate is made of an insulating material that includes a dielectric strength between 3 kV/mm and 10 kV/mm.
Example 7. The device of one of examples 1 to 6, where the insulating material of the insulating substrate includes an epoxy material.
Example 8. The device of one of examples 1 to 7, where the insulating material of the insulating substrate includes a resin or glass.
Example 9. The device of one of examples 1 to 8, where the contact pads are arranged in an array including rows and columns, where the insulating substrate includes a plurality of through openings, each of the plurality of through openings aligned with one of the contact pads.
Example 10. The device of one of examples 1 to 9, where the contact pads are arranged in an array including rows and columns, where the insulating substrate includes a plurality of parallel trenches aligned with a subset of the contact pads in a row or column, the plurality of parallel trenches being separated by one of a plurality of ridges.
Example 11. A semiconductor device including: an enhancement mode GaN power transistor configured to operate at an operating voltage between 20 V and 1000 V and including contact pads; a printed circuit board configured to support operating voltage and including contact surfaces for coupling with the contact pads of the enhancement mode GaN power transistor; and a rigid insulating substrate disposed between the printed circuit board and the enhancement mode GaN power transistor, the contact pads being physically attached to the contact surfaces through a plurality of through holes in the rigid insulating substrate.
Example 12. The device of example 11, further including: an enclosure in which the printed circuit board and the enhancement mode GaN power transistor are disposed, the enclosure hermetically sealing the enhancement mode GaN power transistor and the printed circuit board from an outside environment.
Example 13. The device of one of examples 11 or 12, further including: a low voltage integrated circuit chip attached to the printed circuit board, where the enhancement mode GaN power transistor is configured to provide supply voltage to the low voltage integrated circuit chip.
Example 14. The device of one of examples 11 to 13, where the enhancement mode GaN power transistor includes a Ball Grid Array (BGA) package or a Line Grid Array (LGA) package.
Example 15. The device of one of examples 11 to 14, where the rigid insulating substrate is made of an insulating material that includes a dielectric strength between 3 kV/mm and 10 kV/mm.
Example 16. A method of assembling a semiconductor device, the method including: placing an insulating substrate over a circuit board, the insulating substrate including an insulating material and being a monolithic structure; placing a power semiconductor device over the circuit board and the insulating substrate, where contact pads of the power semiconductor device are aligned with traces for attaching the contact pads of the power semiconductor device on the circuit board, and where adjacent ones of the contact pads are separated by one of a plurality of gaps; and heating the circuit board and the power semiconductor device to cure the insulating substrate and attach the contact pads with the traces.
Example 17. The method of example 16, further including: placing the circuit board in an enclosure including a body and a cover and attaching the cover, the enclosure hermitically sealing the power semiconductor device and the circuit board.
Example 18. The method of one of examples 16 or 17, where the power semiconductor device and the circuit board are hermetically sealed in a 90% N2 and 10% He atmosphere.
Example 19. The method of one of examples 16 to 18, further including: depositing a glaze between the traces on the circuit board.
Example 20. The method of one of examples 16 to 19, where placing the power semiconductor device over the circuit board and the insulating substrate includes: attaching the contact pads to the traces with solder.

## Claims

1. A semiconductor device comprising:
a power semiconductor device (110) comprising contact pads (112), adjacent ones of the contact pads (112) being separated by one of a plurality of gaps (114);
a circuit board (120) comprising traces (122) for coupling with the contact pads (112) of the power semiconductor device (110), the contact pads (112) being physically attached to the traces (122); and
an insulating substrate (130) disposed between the circuit board (120) and the power semiconductor device (110), wherein portions of the insulating substrate (130) are disposed in the plurality of gaps (114), and wherein the insulating substrate (130) has a monolithic structure.

2. The device of claim 1, further comprising:
an enclosure (102) in which the circuit board (120) and the power semiconductor device (110) are disposed, the enclosure (102) hermetically sealing the power semiconductor device (110) and the circuit board (130) from an outside environment.

3. The device of claim 1 or 2, further comprising:
a low voltage integrated circuit chip attached to the circuit board (130).

4. The device of any one of claims 1 to 3, wherein the power semiconductor device (110) comprises a Ball Grid Array (BGA) package or a Line Grid Array (LGA) package.

5. The device of any one of claims 1 to 4, wherein the insulating substrate (130) is made of an insulating material that comprises a dielectric strength greater than 3 kV/mm.

6. The device of any one of claims 1 to 5, wherein the insulating material of the insulating substrate (130) comprises an epoxy material.

7. The device of any one of claims 1 to 6, wherein the insulating material of the insulating substrate (130) comprises a resin or glass.

8. The device of any one of claims 1 to 6,
wherein the contact pads (112) are arranged in an array comprising rows and columns,
wherein the insulating substrate (130) comprises a plurality of through openings, each of the plurality of through openings aligned with one of the contact pads (112).

9. The device of any one of claims 1 to 7, wherein the contact pads (112) are arranged in an array comprising rows and columns, wherein the insulating substrate (130) comprises a plurality of parallel trenches aligned with a subset of the contact pads in a row or column, the plurality of parallel trenches being separated by one of a plurality of ridges.

10. The device of any one of the preceding claims,
wherein the power semiconductor device (110) comprises an enhancement mode GaN power transistor configured to operate at an operating voltage between 20 V and 1000 V.

11. The device of claim 10, wherein the enhancement mode GaN power transistor comprises a Ball Grid Array (BGA) package or a Line Grid Array (LGA) package.

12. A method of assembling a semiconductor device, the method comprising:
placing an insulating substrate (130) over a circuit board (120), the insulating substrate (130) comprising an insulating material and being a monolithic structure;
placing a power semiconductor device (110) over the circuit board (120) and the insulating substrate (130), wherein contact pads (112) of the power semiconductor device (110) are aligned with traces (122) for attaching the contact pads (112) of the power semiconductor device (110) on the circuit board (120), and wherein adjacent ones of the contact pads (112) are separated by one of a plurality of gaps; and
heating the circuit board (120) and the power semiconductor device (110) to cure the insulating substrate (130) and attach the contact pads (112) with the traces (122).

13. The method of claim 12, further comprising:
placing the circuit board (120) in an enclosure (102) comprising a body and a cover and attaching the cover, the enclosure (102) hermitically sealing the power semiconductor device (110) and the circuit board (120.

14. The method of claim 13, wherein the power semiconductor device (110) and the circuit board (120) are hermetically sealed in a 90% N2 and 10% He atmosphere.

15. The method of any one of claims 12 to 14, further comprising:
depositing a glaze between the traces (122) on the circuit board (120).
